# EUROPEAN PATENT APPLICATION

(11) **EP 4 287 059 A1**
(43) Date of publication of application: **06.12.2023**
(21) Application number: 23176532.2
(22) Date of filing: 31.05.2023
(51) Int. Cl.: G06F 30/10, H05K 13/08, G06T 19/20

(54) **SYSTEM AND METHOD FOR GENERATING ASSEMBLY INSTRUCTIONS FOR A PLURALITY OF 3D COMPONENT MODELS**

(30) Priority: 31.05.2022 US 202263347351 P
(71) Applicant: PRATT & WHITNEY CANADA CORP., Longueuil, Québec J4G 1A1 (CA)
(72) Inventor: GELINAS, Simon, (01BE5) Longueuil, J4G 1A1 (CA); ZENG, Yu, (01BE5) Longueuil, J4G 1A1 (CA)
(74) Representative: Dehns

(57) **Abstract**

A method for generating assembly instructions for a plurality of 3D component models (34) comprises: generating the plurality of 3D component models (34) in a CAD environment, the plurality of 3D component models (34) comprising first and second 3D component models (46, 48), respectively comprising a first and a second geometric feature (54, 58); determining first assembly instructions for assembling the plurality of 3D component models (34) into a first 3D model assembly (44) in the CAD environment; determining a plurality of assembly constraints for assembling the plurality of 3D component models (34) into the first 3D model assembly (44) using the first assembly instructions, a first assembly constraint defining a connection relationship between the first and second geometric features (54, 58); modifying the plurality of 3D component models (34) by changing a quantity or composition of the 3D component models (46, 48, 50) or by changing a characteristic of one or more 3D component models (46, 48, 50); and generating second assembly instructions different than the first assembly instructions for assembling the modified plurality of 3D component models (70) into a second 3D model assembly (68) in the CAD environment using at least the first assembly constraint.

## Description

### TECHNICAL FIELD

This disclosure relates generally to computer-aided design (CAD) systems and methods, and more particularly to generating assembly instructions for assembling 3D component models in a CAD system.

### BACKGROUND OF THE ART

Computer-generated three-dimensional (3D) models (e.g., computer-aided design (CAD) models) are frequently used in the development, manufacture, and assembly of components for machinery. Various systems and methods for modeling machinery and machinery components are known in the art. While these known systems and methods have various advantages, there is still room in the art for improvement. There is a need in the art, therefore, for improved systems and methods for generating, manipulating, and maintaining 3D models for machinery and machinery components.

### SUMMARY

An aspect of the present invention provides a method for generating assembly instructions for a plurality of 3D component models, the method comprising: generating the plurality of 3D component models in a CAD environment, the plurality of 3D component models comprising at least a first 3D component model and a second 3D component model, the first 3D component model comprising a first geometric feature, and the second 3D component model comprising a second geometric feature; determining first assembly instructions for assembling the plurality of 3D component models into a first 3D model assembly of the plurality of 3D component models in the CAD environment; determining a plurality of assembly constraints for assembling the plurality of 3D component models into the first 3D model assembly using the first assembly instructions, a first assembly constraint of the plurality of assembly constraints defining a connection relationship between the first geometric feature and the second geometric feature; modifying the plurality of 3D component models by changing a quantity or composition of component models in the plurality of component models or by changing a characteristic of one or more component models of the plurality of component models, the modified plurality of 3D component models comprising the first 3D component model and the second 3D component model; and generating second assembly instructions for assembling the modified plurality of 3D component models into a second 3D model assembly in the CAD environment using at least the first assembly constraint of the plurality of assembly constraints, the second assembly instructions different than the first assembly instructions.

In embodiments of the above, modifying the plurality of 3D component models comprises adding at least one 3D component model to the plurality of 3D component models.

In embodiments of any of the above, modifying the plurality of 3D component models comprises removing at least one 3D component model from the plurality of 3D component models.

In embodiments of any of the above, modifying the plurality of 3D component models comprises changing a component geometry of at least one 3D component model of the plurality of 3D component models.

In embodiments of any of the above, the first geometric feature has a first unique ID, the method further comprising: storing the plurality of assembly constraints in a database; and indexing the first assembly constraint with the first geometric feature using the first unique ID.

In embodiments of any of the above, generating the plurality of 3D component models in a CAD environment comprises generating a first 3D-model representation of the first geometric feature and indexing the first 3D surface representation with the first unique ID, the first 3D-model representation independent of the first 3D component model.

In embodiments of any of the above, the first geometric feature is a first surface of the first 3D component model and the second geometric feature is a second surface of the second 3D component model.

In embodiments of any of the above, the modified plurality of 3D component models comprises a subset of the plurality of 3D component models, the subset of the plurality of 3D component models are assembled together in the second 3D model assembly, and the assembled 3D component models of the subset of the plurality of 3D component models comprise an assembly dimension that is coincident with each 3D component model of the subset of the plurality of 3Dcomponent models, the method further comprising determining an assembly tolerance variation for the assembly dimension.

In embodiments of any of the above, the first assembly constraint identifies a direct assembly connection between first geometric feature and the second geometric feature in the second 3D model assembly.

In embodiments of any of the above, the plurality of 3D component models comprises a third 3D component model and the third 3D component model comprises a third geometric feature, the third geometric feature separated from the first geometric feature in the first 3D model assembly and a second assembly constraint of the plurality of assembly constraints defining a relative relationship between the first geometric feature and the third geometric feature.

Another aspect of the present invention provides a system for generating assembly instructions for a plurality of 3D component models, the system comprising: a processor; and a non-transitory memory in communication with the processor, the non-transitory memory storing: the plurality of 3D component models, the plurality of 3D component models comprising at least a first 3D component model and a second 3D component model, the first 3D component model comprising a first geometric feature, and the second 3D component model comprising a second geometric feature; a plurality of assembly constraints for assembling the plurality of 3D component models into a 3D model assembly in a CAD environment using first assembly instructions, a first assembly constraint of the plurality of assembly constraints comprising an assembly relationship constraint between the first geometric feature and the second geometric feature; and instructions which, when executed, cause the processor to: generate second assembly instructions for assembling a modified plurality of 3D component models, different than the plurality of 3D component models, into a second 3D model assembly in the CAD environment using at least the first assembly constraint of the plurality of assembly constraints, the second assembly instructions different than the first assembly instructions, the modified plurality of 3D component models comprising the first 3D component model and the second 3D component model.

In embodiments of the above, the modified plurality of 3D component models comprises the plurality of 3D component models and at least one additional 3D component model.

In embodiments of any of the above, the modified plurality of 3D component models comprises the plurality of 3D component models with at least one 3D component model removed.

In embodiments of any of the above, the modified plurality of 3D component models comprises the plurality of 3D component models with at least one 3D component model having a changed component geometry.

In embodiments of any of the above, the system further comprises an output device in communication with the processor; wherein the instructions, when executed, further cause the processor to: identify that the first assembly constraint is valid or invalid for the modified plurality of 3D component models; and generate a warning output for the output device if the first assembly constraint is identified as invalid for the modified plurality of 3D component models.

Another aspect of the present invention provides a method for generating assembly instructions for a plurality of 3D component models, the method comprising: providing the plurality of 3D component models in a CAD environment, the plurality of 3D component models comprising at least a first 3D component model and a second 3D component model, the first 3D component model comprising a first geometric surface feature having a first unique ID, and the second 3D component model comprising a second geometric surface feature having a second unique ID; providing a plurality of assembly constraints for assembling the plurality of 3D component models into a first 3D model assembly, a first assembly constraint of the plurality of assembly constraints comprising an assembly relationship constraint, which assembly relationship constraint identifies a direct assembly connection between the first geometric surface feature and the second geometric surface feature; and generating assembly instructions for assembling a modified plurality of 3D component models into a second 3D model assembly, different than the first 3D model assembly, in the CAD environment using at least the first assembly constraint of the plurality of assembly constraints, the modified plurality of 3D component models comprising the first 3D component model and the second 3D component model, the modified plurality of 3D component models further comprising: the plurality of 3D component models and at least one additional 3D component model; the plurality of 3D component models with at least one 3D component model removed; or the plurality of 3D component models with at least one 3D component model having a changed component geometry.

In embodiments of the above, the first assembly constraint is indexed with the first 3D component model using the first unique ID.

In embodiments of any of the above, the plurality of 3D component models comprises a third 3D component model and the third 3D component model comprises a geometric feature, the geometric feature separated from the first geometric surface feature in the first 3D model assembly; a second assembly constraint of the plurality of assembly constraints comprises an assembly geometric constraint between the first geometric surface feature and the geometric feature; and the assembly geometric constraint identifies one or both of a position and an orientation of the first geometric surface feature relative to the geometric feature in the first 3D model assembly.

In embodiments of any of the above, the method further comprises identifying that each assembly constraint of the plurality of assembly constraints is valid or invalid for the modified plurality of 3D component models.

In embodiments of any of the above, the method further comprises generating a warning output if one or more assembly constraints of the plurality of assembly constraints are identified as invalid for the modified plurality of 3D component models.

### DESCRIPTION OF THE DRAWINGS

FIG. 1 illustrates a schematic block diagram of an exemplary computer network, in accordance with one or more embodiments of the present disclosure.
FIG. 2 illustrates a flowchart depicting a method for generating assembly instructions for a plurality of 3D component models, in accordance with one or more embodiments of the present disclosure.
FIG. 3 illustrates a perspective view of a three-dimensional component CAD model, in accordance with one or more embodiments of the present disclosure.
FIG. 4 illustrates perspective views of CAD-based surface representations extracted from surfaces of the CAD model of FIG. 3, in accordance with one or more embodiments of the present disclosure.
FIG. 5 illustrates a block diagram of a portion of the computer network of FIG. 1 including a 3D component model, in accordance with one or more embodiments of the present disclosure.
FIG. 6 illustrates a schematic cross-sectional view of a 3D model assembly, in accordance with one or more embodiments of the present disclosure.
FIG. 7 illustrates a schematic cross-sectional view of another 3D model assembly, in accordance with one or more embodiments of the present disclosure.

### DETAILED DESCRIPTION

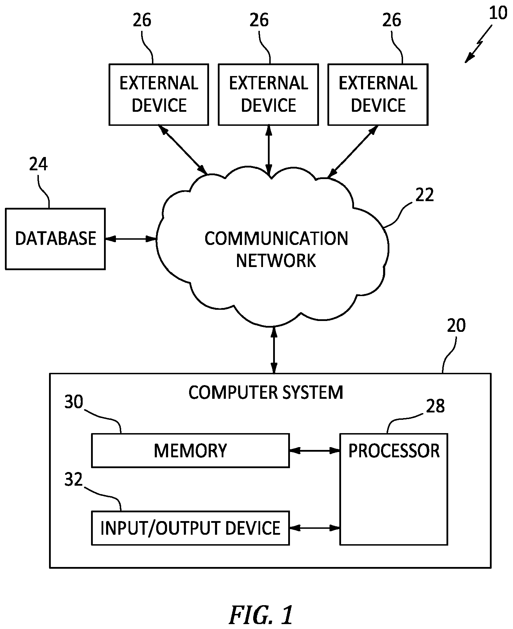

FIG. 1 illustrates a diagram of an exemplary computer network 10. The computer network 10 of FIG. 1 includes a computer system 20, a communication network 22, a database 24, and one or more external devices 26. The computer network 10 of FIG. 1 may be configured to implement one or more aspects of the present disclosure, however, the present disclosure is not limited to the particular computer network 10 of FIG. 1. A person of skill in the art will recognize that portions of the computer network 10 may assume various forms (e.g., digital signal processor, analog device, etc.) capable of performing the functions described herein.

The computer system 20 includes a processor 28, memory 30, and one or more input/output devices 32. The processor 28 may include any type of computing device, computational circuit, processor(s), CPU, computer, or the like capable of executing a series of instructions. Instructions can be directly executable or can be used to develop executable instructions. For example, instructions can be realized as executable or non-executable machine code or as instructions in a high-level language that can be compiled to produce executable or non-executable machine code. Further, instructions also can be realized as or can include data. Computer-executable instructions also can be organized in any format, including routines, subroutines, programs, data structures, objects, modules, applications, applets, functions, etc. The instructions may include an operating system, and/or executable software modules such as program files, system data, buffers, drivers, utilities, and the like. The executable instructions may apply to any functionality described herein to enable the computer system 20 to accomplish the same algorithmically and/or by coordination of device components.

The memory 30 is in signal communication with the processor 28 to allow the processor 28 to execute the series of instructions which are stored in the memory 30. The memory 30 may include a single memory device or a plurality of memory devices; e.g., a computer-readable storage device that can be read, written, or otherwise accessed by a general purpose or special purpose computing device, including any processing electronics and/or processing circuitry capable of executing instructions. The present disclosure is not limited to any particular type of memory device, which may be non-transitory, and may include read-only memory, random access memory, volatile memory, non-volatile memory, static memory, dynamic memory, flash memory, cache memory, volatile or non-volatile semiconductor memory, optical disk storage, magnetic disk storage, magnetic tape, other magnetic storage devices, or any other medium capable of storing one or more instructions, and/or any device that stores digital information.

The one or more input/output devices 32 are in signal communication with the processor 28. Communications between the processor 28 and the one or more input/output devices 32 may be via a hardwire connection or via a wireless connection. The one or more input/output devices 32 may include one or more input devices configured, for example, to enable a user to enter data and/or instructions to the computer system 20. Examples of an input device may include, but are not limited to, a keyboard, a mouse, a touchscreen, and a 3D laser scanning system. The one or more input/output devices 32 may additionally or alternatively include one or more output devices configured, for example, to display information or to transfer data from the computer system 20. Examples of an output device may include, but are not limited to, a computer monitor or other optical display, a printer, and audio speakers.

The computer system 20 of the present disclosure is configured to implement a computer-aided drafting (CAD) and/or a computer-aided manufacturing (CAM) system, platform, and/or software (referred to herein as a "CAD environment") which is capable of generating, manipulating, and assembling three-dimensional (3D) models of an object (e.g., a component) in a simulated 3D space. The present disclosure is not limited to any particular CAD or CAM system, platform, or software. The 3D model may be a mathematical coordinate-based representation of the geometric features of an object in three dimensions. Examples of geometric features may include, but are not limited to, surfaces, edges, vertices, and volumes of an object. The 3D model may be generated algorithmically (e.g., by procedural modeling), by scanning a physical object, or by any other suitable process for obtaining data for representing the 3D shape of an object in the CAD environment. The 3D model may be defined by a solid model or by a shell or boundary model using any suitable representation technique including, but not limited to, boundary definition representation, point cloud representation, and the like.

The communication network 22 of FIG. 1 is configured to facilitate signal communication between the components of the computer network 10 including, for example, the computer system 20, the database 24, and the one or more external devices 26. The communication network 22 may include any suitable electronic communication network or combination of electronic communication networks including, but not limited to, wired and/or wireless local area networks, internet-based networks, cloud-based storage and communication networks, and the like. The communication network 22 may allow remote electronic communications between the computer system 20 and one or more devices such as, but not limited to, the database 24 and/or the one or more external devices 26.

The database 24 may include a single memory device or a plurality of memory devices; e.g., a computer-readable storage device that can be read, written, or otherwise accessed by a general purpose or special purpose computing device, including any processing electronics and/or processing circuitry capable of executing instructions. The present disclosure is not limited to any particular type of memory device, which may be non-transitory, and may include read-only memory, random access memory, volatile memory, non-volatile memory, static memory, dynamic memory, flash memory, cache memory, volatile or non-volatile semiconductor memory, optical disk storage, magnetic disk storage, magnetic tape, other magnetic storage devices, or any other medium capable of storing one or more instructions, and/or any device that stores digital information. The database 24 of FIG. 1 is in signal communication with the components of the computer network 10 such as, but not limited to, the computer system 20 and the one or more external devices 26, via the communication network 22. The database 24 may, thereby, facilitate access to stored instructions and data from multiple components of the computer network 10 such as, but not limited to, the computer system 20 and the one or more external devices 26. The database 26 of FIG. 1 is located external to the computer system 20. Alternatively, the database 24 may be integral to the computer system 20. For example, the database 24 may be integrated with the memory 30.

The one or more external devices 26 may include, for example, one or more computer workstations which may be similar to the computer system 20 of FIG. 1. The one or more external devices 26 may be configured to operate CAD or CAM software capable of generating, manipulating, and assembling three-dimensional (3D) models of an object (e.g., a component) in a simulated 3D space. The one or more external devices 26 may include manufacturing equipment, inspection equipment, and the like. Examples of manufacturing equipment may include, but are not limited to, computer numerical control (CNC) manufacturing equipment, multi-axis milling equipment, grinding equipment, additive manufacturing equipment, component casting equipment, and the like. Examples of inspection equipment may include, but are not limited to, optical scanning equipment, laser scanning equipment, pneumatic gauging equipment, and the like. The manufacturing equipment and the inspection equipment may be configured to access or receive the 3D models and perform one or more manufacturing or inspection steps using the information defined by or included with the 3D models.

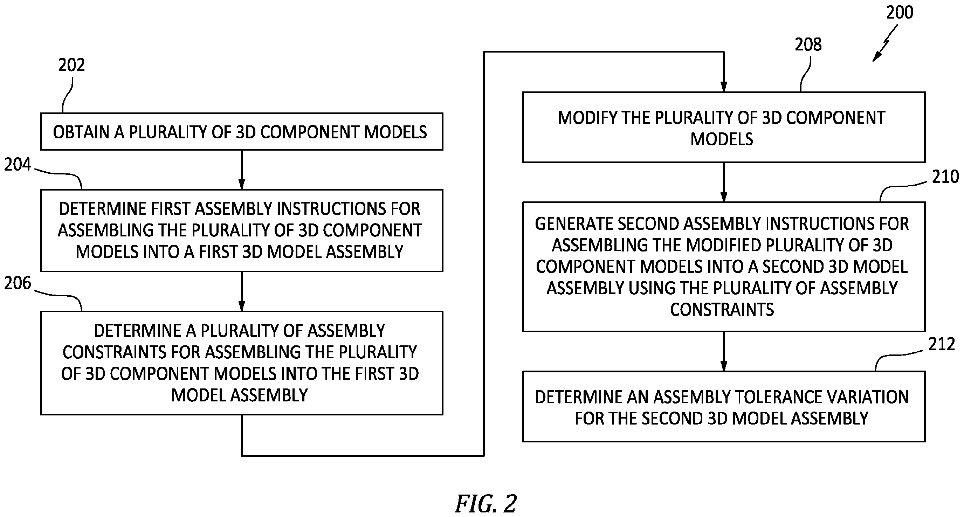

FIG. 2 illustrates a flow chart of a method 200 for generating assembly instructions for a plurality of 3D component models. For ease of description, the method 200 is described below with reference to the computer network 10 of FIG. 1. For example, the memory 30 may include instructions which, when executed by the processor 28, cause the computer system 20 or its processor 28 to perform one or more steps of the method 200. The method 200, however, may alternatively be performed with other computer network or computer system configurations. Unless otherwise noted herein, it should be understood that the steps of method 200 are not required to be performed in the specific sequence in which they are discussed below and, in various embodiments, the steps of method 200 may be performed separately or simultaneously. Further, it should be understood that not all of the steps of the method 200, discussed below, may be required unless otherwise described herein.

Referring to FIGS. 2-5, Step 202 includes generating, providing, or otherwise obtaining a plurality of 3D component models 34 in a CAD environment, which CAD environment may be implemented by the computer system 20 (see FIG. 1). The plurality of 3D component models 34 may be representative of a respective plurality of components (e.g., physical components), which plurality of components may be configured for assembly to form an apparatus (e.g., a mechanical apparatus such as, but not limited to, a gas turbine engine for an aircraft). Generation of the plurality of 3D component models 34 in the CAD environment may be performed as part of a design process for an apparatus. The plurality of 3D component models 34 may be stored, for example, in the database 24 and/or memory 30 for access by one or more components of the computer network 10 (see FIG. 1).

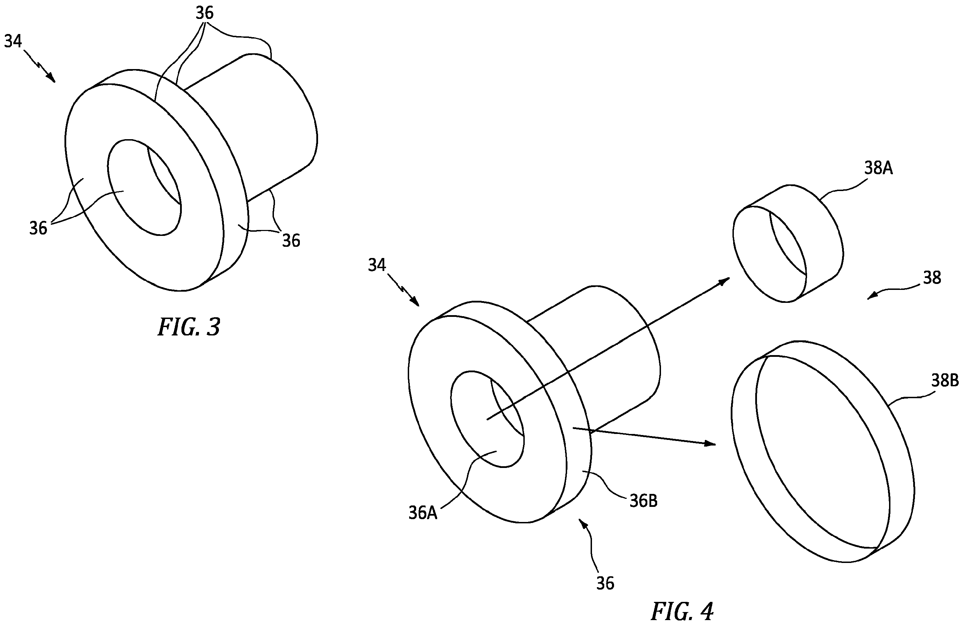

FIG. 3 illustrates a perspective view of an exemplary 3D component model 34. The 3D component model 34 of FIG. 3 includes a plurality of geometric features 36. The plurality of geometric features 36 of FIG. 3 include surfaces and edges of the 3D component model 34. The geometric features 36 of the present disclosure, however, are not limited to component model surfaces and edges.

FIG. 4 illustrates a perspective view of the exemplary 3D component model 34 of FIG. 3 and 3D geometric feature representation models 38. In some embodiments, Step 202 may include extracting geometric feature information from the 3D component model 34 and generating one or more 3D geometric feature representation models 38. Each 3D geometric feature representation model 38 may be a representation of a respective geometric feature of a 3D component model 34, such as the 3D component model 34 of FIG. 4. As an example, the plurality of geometric features 36 of the 3D component model 34 of FIG. 4 includes a first surface 36A and a second surface 36B. Geometric feature information of the 3D component model 34 for the first surface 36A may be extracted to generate a first 3D geometric feature representation model 38A which is representative of the first surface 36A. Similarly, geometric feature information of the 3D component model 34 for the second surface 36B may be extracted to generate a second 3D geometric feature representation model 38B which is representative of the second surface 36B. The 3D geometric feature representation models 38 may be generated in the CAD environment and may be unique models which are independent of the associated 3D component model 34. The 3D geometric feature representation models 38 may be stored, for example, in the database 24 or memory 30 independent of the associated 3D component model 34.

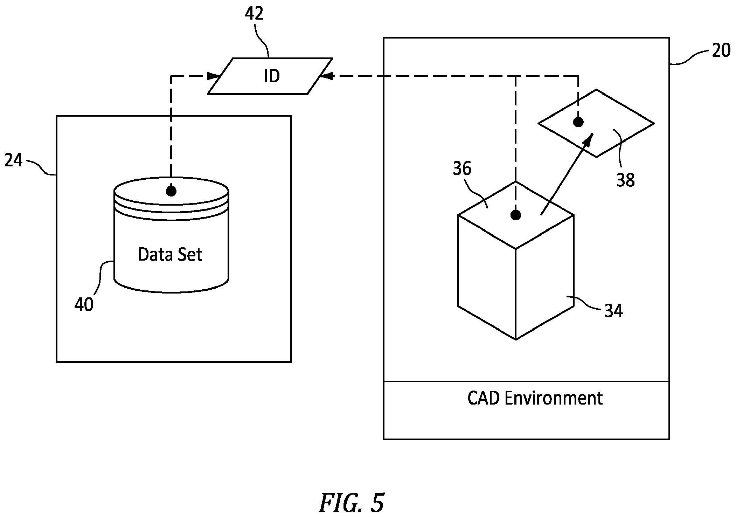

Step 202 may further include storing information associated with a geometric feature 36 of the plurality of geometric features 36 of the 3D component model 34. The information associated with the geometric feature 36 may be stored as a data set 40, for example, in the database 24 (see FIG. 5). The data set 40 may be linked with a respective geometric feature 36 by a unique ID 42 which is unique for the respective geometric feature 36. The unique ID 42 may be a persistent ID (e.g., a fixed reference code or value). For example, the unique ID 42 may not change in response to a change in the geometry (e.g., size, shape, dimension, etc.) of the associated geometric feature 36. The data set 40 may additionally or alternatively be linked with a 3D geometric feature representation model 38 for the respective geometric feature 36 by the unique ID 42. FIG. 5 illustrates a block diagram depicting an exemplary relationship between the geometric feature 36 of a 3D component model 34 in the CAD environment of the computer system 20 and the data set 40 stored in the database 24. The geometric feature 36 and the data set 40 of FIG. 5 are linked by the unique ID 42 of FIG. 5. The 3D geometric feature representation model 38 of FIG. 5 is additionally linked to the data set 40 by the unique ID 42. Each geometric feature 36 for each 3D component model 34 of the plurality of 3D component models 34 may be linked to a respective data set 40 by a respective unique ID 42.

Each data set 40 may include product manufacturing information (PMI). The PMI may include geometric dimensioning and tolerancing (GD&T) information for a geometric feature 36. The GD&T information may describe the nominal geometry of a manufacturable component (e.g., a component which is manufacturable in conformance with the GD&T information of a 3D component model) and the allowable manufacturing tolerance variation for the component. The GD&T information may describe geometric characteristics for a geometric feature 36. Examples of GD&T information include geometric characteristics of a geometric feature 36 such as, but not limited to, dimensions (e.g., length, width, height), flatness, circularity, cylindricity, angularity, concentricity, coincidence, parallelism, perpendicularity, and the like, as well as acceptable manufacturing tolerance limits for each geometric characteristic. The GD&T information of the data set 40 may conform to one or more GD&T standards including, but not limited to, the American Society of Mechanical Engineers (ASME) Y14.5 standard, the International Organization for Standardization (ISO) standard, and the like. The PMI may include functional and/or contextual information for a geometric feature 36 such as, but not limited to, stress peak area, airflow direction with respect to the geometric feature 36, stack-up information (e.g., bearing stack-up information), design notes, etc. The PMI may include life cycle information for the geometric feature 36, such as, but not limited to, repair history, failure history, inspection history, and/or information gathered during component and/or equipment operation which may be used for future part design.

Step 202 may further include identifying one or more interfaces for one or more geometric features 36 of the plurality of geometric features 36 of the 3D component model 34. An "interface," as described herein, refers to all or a portion of a geometric feature 36 (e.g., a portion of a geometric feature 36 surface) which is intended to directly contact another geometric feature 36 (e.g., a geometric feature 36 of another 3D component model 34) in the CAD environment. Identifying an interface of a geometric feature 36 may include identifying the location, geometric boundaries, surface area, shape, etc. of the interface. Identifying an interface of a geometric feature 36 may include identifying a contact relationship for the interface such as, but not limited to, welding, bonding, abutment, fastener attachment (e.g., threaded attachment), and the like. The identifying information for the one or more interfaces of each geometric feature 36 may be stored in the data set 40 for the respective geometric feature 36.

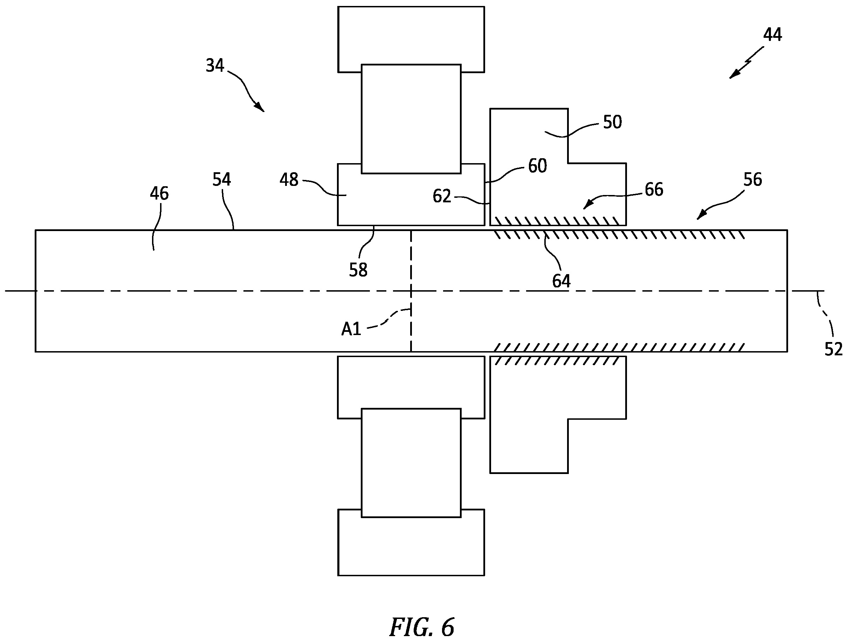

Referring to FIGS. 2 and 6, Step 204 includes determining assembly instructions for assembling the plurality of 3D component models 34 into a 3D model assembly 44 in the CAD environment. The assembly instructions (e.g., computer-readable code, coordinates, or other data), when executed by the computer system 20 (e.g., the processor 28), cause the computer system 20 to assemble the plurality of 3D component models 34 into the 3D model assembly 44 in the CAD environment. The assembly instructions may be defined (e.g., by the computer system 20, see FIG. 1) through manipulation of the plurality of 3D component models 34 in the CAD environment, for example, by a user. As previously discussed, the plurality of 3D component models 34 may be representative of a respective plurality of components (e.g., physical components), which plurality of components may be configured for assembly to form an apparatus. The 3D model assembly 44 may, thus, be representative of an assembled apparatus.

In a first example of a 3D model assembly, FIG 6. illustrates an exemplary 3D model assembly 44 including a plurality of 3D component models 34. The plurality of component models 34 of FIG. 6 includes a first component model 46, a second component model 48, and a third component model 50. The first component model 46 may be representative of a shaft for a rotational equipment assembly, which shaft may be configured for rotation about a centerline axis 52 (e.g., a rotational axis). The first component model 46 includes a first geometric feature 54 which is representative of an outer shaft surface disposed about the centerline axis 52. The first geometric feature 54 includes a portion 56 which is representative of a threaded portion of the outer shaft surface. The second component model 48 may be representative of an inner race for a bearing used to rotationally support the shaft. The second component model 48 includes a second geometric feature 58 and a third geometric feature 60. The second geometric feature 58 and the third geometric feature 60 are representative of respective surfaces of the inner race. The second geometric feature 58 is mounted to the first geometric feature 54 in the CAD environment. The second geometric feature 58 may be positioned, relative to the first geometric feature 54, so that the second geometric feature 58 is centered at an axial position A1 corresponding to an approximate axial center of the first geometric feature 54. The third component model 50 may be representative of a nut configured to threadably engage the shaft and to provide axial support for the inner race. The third component model 50 includes a fourth geometric feature 62 and a fifth geometric feature 64. The fourth geometric feature 62 and the fifth geometric feature 64 are representative of respective surfaces of the nut. The fourth geometric feature 62 abuts the third geometric feature 60 in the CAD environment. The fifth geometric feature 64 includes a portion 66 which is representative of a threaded portion of the nut. The portion 66 of the fifth geometric feature 64 is threadably engaged with the portion 56 of the first geometric feature 54 in the CAD environment. In this example, the assembly instructions for assembling the plurality of 3D component models 34 of FIG. 6 (e.g., component models 46, 48, 50), when executed by the computer system 20 (e.g., the processor 28), cause the computer system 20 to assemble the plurality of 3D component models 34 into the 3D model assembly 44 of FIG. 6 in the CAD environment. It should be understood that the 3D model assembly 44 of the present disclosure is not limited to the particular 3D model assembly 44 of FIG. 6, to any particular number of 3D component models 34 or geometric features 36, or to any particular relationship between the geometric features 36 (see FIGS. 3-5) in the CAD environment. Similarly, the plurality of 3D component models 34 of the present disclosure is not limited to the particular component models 46, 48, 50 of FIG. 6.

Step 206 includes determining a plurality of assembly constraints for assembling the plurality of 3D component models 34 into the 3D model assembly 44 using the assembly instructions. An assembly constraint may be understood as a required algorithm condition for assembly instructions to be acceptable (e.g., a valid solution) for assembling the 3D model assembly 44 from the plurality of 3D component models 34. Each assembly constraint may define a position and an orientation for a respective geometric feature 36 of the plurality of geometric features 36 for a 3D component model 34. The position and the orientation defined by each assembly constraint may be defined with respect to another geometric feature 36 (e.g., a geometric feature 36 of another 3D component model 34). For example, the assembly constraint may define a direct assembly connection for the geometric feature 36 with another geometric feature 36. Alternatively, the position and the orientation defined by each assembly constraint may be defined with respect to a reference point (e.g., a zero position) within the CAD environment. The assembly constraint may be expressed as or otherwise include a GD&T definition (e.g., defining angularity, concentricity, coincidence, parallelism, perpendicularity, etc. of a geometric feature 36).

An assembly constraint for a geometric feature 36 may define a connection relationship with another geometric feature 36 (see FIGS. 3-5). For example, an assembly constraint for a first geometric feature (e.g., the first geometric feature 54 of FIG. 6) may define a direct connection or interaction (e.g., a fixed connection, abutment, sliding engagement, threaded engagement, coincidence, angularity, etc.) between the first geometric feature and a second geometric feature (e.g., the second geometric feature 58 of FIG. 6). In some embodiments, for example, the assembly constraint may identify a direct connection or interaction between an interface of the associated geometric feature 36 and an interface of another geometric feature 36. An assembly constraint for a geometric feature 36 may additionally or alternatively define a relative relationship with another geometric feature 36 (see FIGS. 3-5). For example, an assembly constraint for a first geometric feature may define a relative positioning (e.g., angularity, concentricity, parallelism, perpendicularity, etc.) between the first geometric feature 36 and a second geometric feature 36, which does not necessarily require contact between the first geometric feature 36 and the second geometric feature 36. Each assembly constraint may be stored in the data set 40 for a respective geometric feature 36 (see FIG. 5). For example. each assembly constraint may be linked to the respective geometric feature 36 by the unique ID 42.

Referring to FIGS. 2, 6, and 7, Step 208 includes modifying the plurality of 3D component models 34 (e.g., modifying a characteristic of the plurality of 3D component models 34, as a whole). Modifying the plurality of 3D component models 34 may include changing a quantity or composition of the 3D component models 34 in the plurality of 3D component models 34. For example, modifying the plurality of 3D component models 34 may include adding at least one 3D component model 34 to the plurality of 3D component models 34. For further example, modifying the plurality of 3D component models 34 may include removing at least one 3D component model 34 from the plurality of 3D component models 34. Modifying the plurality of 3D component models 34 may additionally or alternatively include changing a characteristic of one or more 3D component models 34 of the plurality of component models 34. For example, modifying the plurality of 3D component models 34 may include changing a shape, size, dimension, quality, etc. of at least one geometric feature 36 of a 3D component model 34 in the plurality of 3D component models 34.

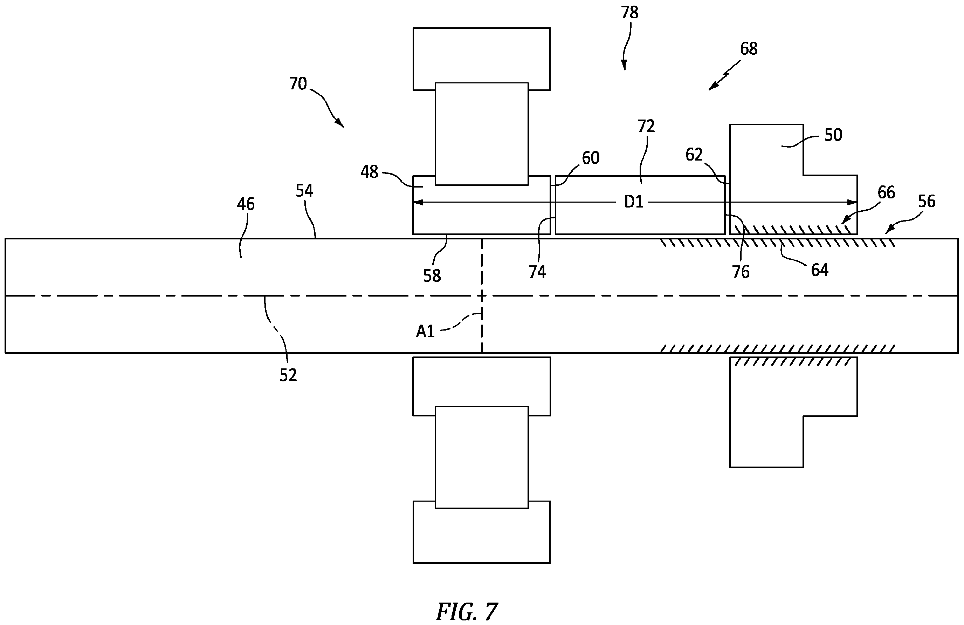

In a second example of a 3D model assembly, FIG. 7 illustrates an exemplary modified 3D model assembly 68 including a modified plurality of 3D component models 70. The modified 3D model assembly 68 of FIG. 7 represents an intended configuration of the modified plurality of 3D component models 70. In other words, Step 208 does not require that the modified plurality of 3D component models 70 be assembled in the CAD environment to form the modified 3D model assembly 68. The modified 3D model assembly 68 of FIG. 7 includes the first component model 46, the second component model 48, and the third component model 50 of the plurality of 3D component models 34 of FIG. 6. In the modified plurality of 3D component models 70, the first component model 46 has been modified, relative to the first component model 46 of FIG. 6, to have a greater axial length (e.g., relative to the centerline axis 52). Additionally, the modified plurality of 3D component models 70 has been modified, relative to the plurality of 3D component models 34 of FIG. 6, to include a fourth component model 72. The fourth component model 72 may be representative of a tubular spacer configured for axial positioning between the second component model 48 (e.g., representative of an inner race for a bearing) and the third component model 50 (e.g., representative of a nut). The fourth component model 72 includes a sixth geometric feature 74 and a seventh geometric feature 76. The sixth geometric feature 74 and the seventh geometric feature 76 are representative of axially-opposing surfaces of the tubular spacer. The sixth geometric feature 74 abuts the third geometric feature 60 in the CAD environment. The seventh geometric feature 76 abuts the fourth geometric feature 62 in the CAD environment. It should be understood that the modified 3D model assembly 68 of the present disclosure is not limited to the particular modified 3D model assembly 68 of FIG. 7, to any particular number of 3D component models 34 or geometric features 36, or to any particular relationship between the geometric features 36 (see FIGS. 3-5) in the CAD environment. Similarly, the modified plurality of 3D component models 70 of the present disclosure is not limited to the particular component models 46, 48, 50, 72 of FIG. 7.

Step 208 may further include determining additional assembly constraints for the modified plurality of 3D component models 70 relative to the plurality of assembly constraints for the plurality of 3D component models 34. Step 208 may additionally or alternatively include modifying one or more assembly constraints of the plurality of assembly constraints for the plurality of 3D component models 34. For example, the plurality of assembly constraints for the modified plurality of 3D component models 70 may include an additional assembly constraint for the sixth geometric feature 74 which defines a position and an orientation of the sixth geometric feature 74 and/or a connection relationship (e.g., abutment) with the third geometric feature 60. For further example, an assembly constraint for the third geometric feature 60 of FIG. 7 (e.g., for the modified plurality of 3D component models 70) may be modified, relative to the assembly constraint for the third geometric feature 60 of FIG. 6, to define a position and an orientation of the second geometric feature 60 and/or a connection relationship (e.g., abutment) with the sixth geometric feature 74.

Step 208 may further include identifying whether each assembly constraint of the plurality of assembly constraints is valid or invalid for the modified plurality of 3D component models 70. For example, the computer system 20 (see FIG. 1) may continuously evaluate the validity or invalidity of each assembly constraint of the plurality of assembly constraints as the plurality of 3D component models 34 are modified. A valid assembly constraint may reflect an assembly constraint (e.g., of a first geometric feature with a second geometric feature) which is executable in the CAD environment (e.g., when executing the assembly instructions for a 3D model assembly). In contrast, an invalid assembly constraint may reflect an inexecutable assembly constraint (e.g., of a first geometric feature with a second geometric feature). For example, an assembly constraint defining a connection relationship of a first geometric feature with a second geometric feature may be invalid if the second geometric feature is deleted or the second geometric feature is modified so that the connection relationship can no longer be established in the CAD environment. If an assembly constraint is identified as invalid, the computer system 20 may provide a warning (e.g., a warning output) to a user identifying and/or describing the invalid assembly constraint (e.g., including by providing the unique ID 42 linking the assembly constraint with a respective geometric feature). The computer system 20 may prevent the user from storing (e.g., in a data set 40, see FIG. 5) a geometric feature (e.g., a modified geometric feature) which is associated with one or more assembly constraints identified as invalid.

Step 210 includes generating assembly instructions for assembling the modified plurality of 3D component models 70 into the modified 3D model assembly 68 in the CAD environment. Generating the assembly instructions for the modified 3D model assembly 68 may be performed by the computer system 20 using the plurality of assembly constraints for the modified plurality of 3D component models 70. Generating the assembly instructions for assembling the modified 3D model assembly 68 may be performed automatically by the computer system 20 (e.g., without user input such as manipulation of the modified plurality of 3D component models 70 in the CAD environment). The generated assembly instructions for assembling the modified 3D model assembly 68 may be generated such that all of the assembly constraints of the plurality of assembly constraints for the modified plurality of 3D component models 70 are satisfied. The generated assembly instructions for assembling the modified 3D model assembly 68 may subsequently be executed by the computer system 20 to assemble the modified plurality of 3D component models 70 into the modified 3D model assembly 68 in the CAD environment.

In the design, testing, and manufacturing of a mechanical apparatus, multiple configurations of the mechanical apparatus (e.g., a particular apparatus model) may be developed. The different configurations of the apparatus may be relatively similar to one another. For example, the large majority of components of apparatus configurations may be the same, but the configurations may include one or more relatively minor differences in component composition and/or assembly. Generating and sustaining 3D models (e.g., 3D CAD models) for each configuration of an apparatus can be expensive and time consuming. The systems and methods of the present disclosure facilitate the generation of 3D models for multiple apparatus configurations without the need for a user to manually assemble each of the 3D models in the CAD environment. The component models for an apparatus model may be loaded, unloaded, and/or relocated in the CAD environment each time a configuration of the apparatus changes. Accordingly, numerous configurations of an apparatus may be modeled with limited user input.

In some embodiments, in Step 212, an assembly tolerance variation may be determined for the modified 3D model assembly 68. The assembly tolerance variation may be determined for a subset (e.g., a stack-up) of the plurality of 3D component models 34, 70. For example, the assembly tolerance variation may identify a permissible manufacturing limit of a physical dimension for a stack-up of components manufactured in conformance with the subset of the plurality of 3D component models 34, 70. Referring again to the example modified 3D model assembly 68 of FIG. 7, the component models 48, 50, 72 may form a subset 78 of the modified plurality of 3D component models 70. For example, an assembly tolerance variation for the subset 78 may be determined for a dimension D1 representing an axial span of the subset 78. Dimensional tolerances stored in data sets 40 for one or more respective geometric features 36 (see FIGS. 3-5) of each of the component models 48, 50, 72 for the subset 78 may be used to determine the assembly tolerance variation for the subset 78. In some embodiments, a first end and a second end of a tolerance dimension (e.g., dimension D1) may be indexed with a first geometric feature 36 and a second geometric feature 36, respectively. Accordingly, modification of the plurality of 3D component models 34, 70 (e.g., adding a 3D component model to the subset 78 between the first end and the second end of the dimension D1) may cause the computer system 20 to automatically recalculate an assembly tolerance variation for the associated tolerance dimension.

It is noted that various connections are set forth between elements in the preceding description and in the drawings. It is noted that these connections are general and, unless specified otherwise, may be direct or indirect and that this specification is not intended to be limiting in this respect. A coupling between two or more entities may refer to a direct connection or an indirect connection. An indirect connection may incorporate one or more intervening entities. It is further noted that various method or process steps for embodiments of the present disclosure are described in the following description and drawings. The description may present the method and/or process steps as a particular sequence. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the description should not be construed as a limitation.

Furthermore, no element, component, or method step in the present disclosure is intended to be dedicated to the public regardless of whether the element, component, or method step is explicitly recited in the claims. As used herein, the terms "comprises", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various aspects of the present disclosure have been disclosed, it will be apparent to those of ordinary skill in the art that many more embodiments and implementations are possible within the scope of the present disclosure. For example, the present disclosure as described herein includes several aspects and embodiments that include particular features. Although these particular features may be described individually, it is within the scope of the present disclosure that some or all of these features may be combined with any one of the aspects and remain within the scope of the present disclosure. References to "various embodiments," "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described. Accordingly, the present disclosure is not to be restricted except in light of the attached claims and their equivalents.

## Claims

1. A method for generating assembly instructions for a plurality of 3D component models (34), the method comprising:
generating the plurality of 3D component models (34) in a CAD environment, the plurality of 3D component models (34) comprising at least a first 3D component model (46) and a second 3D component model (48), the first 3D component model (46) comprising a first geometric feature (54), and the second 3D component model (48) comprising a second geometric feature (58);
determining first assembly instructions for assembling the plurality of 3D component models (34) into a first 3D model assembly (44) of the plurality of 3D component models (34) in the CAD environment;
determining a plurality of assembly constraints for assembling the plurality of 3D component models (34) into the first 3D model assembly (44) using the first assembly instructions, a first assembly constraint of the plurality of assembly constraints defining a connection relationship between the first geometric feature (54) and the second geometric feature (58);
modifying the plurality of 3D component models (34) by changing a quantity or composition of the 3D component models (46, 48, 50) in the plurality of 3D component models (34) or by changing a characteristic of one or more 3D component models (46, 48, 50) of the plurality of 3D component models (34), the modified plurality of 3D component models (70) comprising the first 3D component model (46) and the second 3D component model (48); and
generating second assembly instructions for assembling the modified plurality of 3D component models (70) into a second 3D model assembly (68) in the CAD environment using at least the first assembly constraint of the plurality of assembly constraints, the second assembly instructions different than the first assembly instructions.

2. The method of claim 1, wherein modifying the plurality of 3D component models (34) comprises adding at least one 3D component model (72) to the plurality of 3D component models (34).

3. The method of claim 1 or 2, wherein modifying the plurality of 3D component models (34) comprises removing at least one 3D component model (46, 48, 50) from the plurality of 3D component models (34).

4. The method of claim 1, 2 or 3, wherein modifying the plurality of 3D component models (34) comprises changing a component geometry of at least one 3D component model (46, 48, 50) of the plurality of 3D component models (34).

5. The method of any preceding claim, wherein the first geometric feature (36) has a first unique ID (42), the method further comprising storing the plurality of assembly constraints in a database (40) and indexing the first assembly constraint with the first geometric feature (36) using the first unique ID (42).

6. The method of claim 5, wherein generating the plurality of 3D component models (34) in a CAD environment comprises generating a first 3D-model representation (38) of the first geometric feature (36) and indexing the first 3D-model representation (38) with the first unique ID (42), the first 3D-model representation (38) independent of the first 3D component model (34; 46).

7. The method of any preceding claim, wherein the first geometric feature (54) is a first surface of the first 3D component model (46) and the second geometric feature (58) is a second surface of the second 3D component model (48), and/or wherein the first assembly constraint identifies a direct assembly connection between first geometric feature (54) and the second geometric feature (58) in the second 3D model assembly (68).

8. The method of any preceding claim, wherein the modified plurality of 3D component models (70) comprises a subset (78) of the plurality of 3D component models (70), the subset (78) of the plurality of 3D component models (70) are assembled together in the second 3D model assembly (68), and the assembled 3D component models (48, 50, 72) of the subset (78) of the plurality of 3D component models (70) comprise an assembly dimension that is coincident with each 3D component model (48, 50, 72) of the subset (78) of the plurality of 3D component models (70), the method further comprising determining an assembly tolerance variation for the assembly dimension.

9. The method of any preceding claim, wherein:
the plurality of 3D component models (34) comprises a third 3D component model (50) and the third 3D component model (50) comprises a third geometric feature (62), the third geometric feature separated from the first geometric feature (54) in the first 3D model assembly (44); and
a second assembly constraint of the plurality of assembly constraints defining a relative relationship between the first geometric feature (54) and the third geometric feature (62),
wherein, optionally, the second assembly constraint comprises an assembly geometric constraint between the first geometric feature (54) and the third geometric feature (62), and the assembly geometric constraint identifies one or both of a position and an orientation of the first geometric feature (54) relative to the third geometric feature (62) in the first 3D model assembly (44).

10. The method of any preceding claim, further comprising identifying that each assembly constraint of the plurality of assembly constraints is valid or invalid for the modified plurality of 3D component models (70), optionally further comprising generating a warning output if one or more assembly constraints of the plurality of assembly constraints are identified as invalid for the modified plurality of 3D component models (70).

11. A system (20) for generating assembly instructions for a plurality of 3D component models (34), the system (20) comprising:
a processor (28); and
a non-transitory memory (30) in communication with the processor (38) , the non-transitory memory (30) storing:
the plurality of 3D component models (34), the plurality of 3D component models (34) comprising at least a first 3D component model (46) and a second 3D component model (48), the first 3D component model (46) comprising a first geometric feature (54), and the second 3D component model (46) comprising a second geometric feature (58);
a plurality of assembly constraints for assembling the plurality of 3D component models (34) into a 3D model assembly (44) in a CAD environment using first assembly instructions, a first assembly constraint of the plurality of assembly constraints comprising an assembly relationship constraint between the first geometric feature (54) and the second geometric feature (58); and
instructions which, when executed, cause the processor (28) to:
generate second assembly instructions for assembling a modified plurality of 3D component models (70), different than the plurality of 3D component models (34), into a second 3D model assembly (68) in the CAD environment using at least the first assembly constraint of the plurality of assembly constraints, the second assembly instructions different than the first assembly instructions, the modified plurality of 3D component models (70) comprising the first 3D component model (46) and the second 3D component model (48).

12. The system of claim 11, wherein the modified plurality of 3D component models (70) comprises the plurality of 3D component models (46, 48, 50) and at least one additional 3D component model (72).

13. The system of claim 11 or 12, wherein the modified plurality of 3D component models (70) comprises the plurality of 3D component models (46, 48, 50) with at least one 3D component model (46, 48, 50) removed.

14. The system of claim 11, 12 or 13, wherein the modified plurality of 3D component models (70) comprises the plurality of 3D component models (34) with at least one 3D component model (46, 48, 50) having a changed component geometry.

15. The system of any of claims 11 to 14, further comprising an output device (32) in communication with the processor (28);
wherein the instructions, when executed, further cause the processor (28) to:
identify that the first assembly constraint is valid or invalid for the modified plurality of 3D component models (70); and
generate a warning output for the output device if the first assembly constraint is identified as invalid for the modified plurality of 3D component models (70).
